(19) Europäisches Patentamt
European Patent Office
Office européen des brevets

(11) **EP 3 555 644 B1**

(12) **EUROPÄISCHE PATENTSCHRIFT**

(45) Veröffentlichungstag und Bekanntmachung des Hinweises auf die Patenterteilung:
**26.04.2023 Patentblatt 2023/17**

(21) Anmeldenummer: **18818979.9**

(22) Anmeldetag: **05.11.2018**

(51) Internationale Patentklassifikation (IPC):
**G01R 27/26** (2006.01)      **G01R 31/64** (2020.01)

(52) Gemeinsame Patentklassifikation (CPC):
**G01R 27/2605; G01R 31/64**

(86) Internationale Anmeldenummer:
**PCT/DE2018/200099**

(87) Internationale Veröffentlichungsnummer:
**WO 2019/101273 (31.05.2019 Gazette 2019/22)**

(54) **VERFAHREN UND BEWERTUNGSEINHEIT ZUM ERMITTELN DER RESTLEBENSDAUER EINES KONDENSATORS SOWIE SYSTEM**

METHOD AND ASSESSMENT UNIT FOR DETERMINING THE REMAINING SERVICE LIFE OF A CAPACITOR, AND SYSTEM

PROCÉDÉ ET UNITÉ D'ÉVALUATION PERMETTANT DE DÉTERMINER LA DURÉE DE VIE RESTANTE D'UN CONDENSATEUR, AINSI QUE SYSTÈME

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.11.2017 DE 102017221096**

(43) Veröffentlichungstag der Anmeldung:
**23.10.2019 Patentblatt 2019/43**

(73) Patentinhaber: **Ziehl-Abegg SE 74653 Künzelsau (DE)**

(72) Erfinder: **SCHNELL, Marco 74629 Pfedelbach-Renzen (DE)**

(74) Vertreter: **Ullrich & Naumann PartG mbB Schneidmühlstrasse 21 69115 Heidelberg (DE)**

(56) Entgegenhaltungen:
**DE-A1-102012 215 963      DE-T5-112009 000 643 US-A1- 2009 088 993**

**Beschreibung**

Die Erfindung betrifft ein Verfahren und eine Bewertungseinheit zum Ermitteln der Restlebensdauer eines Kondensators, wobei der Kondensator zumindest einmalig aufgeladen und entladen wird. Die Erfindung betrifft ferner ein System, das eine derartige Bewertungseinheit sowie eine Schaltung mit mindestens einem zu bewertenden Kondensator umfasst.

In der Praxis ist es immer wieder von Bedeutung, die Restlebensdauer eines Bauteils oder einer Baugruppe abzuschätzen oder zu bestimmen. Dies ist immer dann von ganz besonderer Bedeutung, wenn ein Ausfall zu Folgeschäden führen würde, wie es beispielsweise bei thermisch kritischen Anwendungen der Fall ist. Wenn beispielsweise in einem Serverraum die Kühlanlage oder ein Teil davon ausfällt, kann dies zu einer Überhitzung und einem Betriebsausfall oder gar einer Zerstörung von Servern und anderer Hardware führen. Ähnlich kritisch ist auch die Kühlung anderer komplexer und/oder teurer elektronischer Anlagen. In derartigen Anwendungsszenarien ist es hilfreich, wenn ein drohender Ausfall bereits frühzeitig angezeigt wird, damit die vom Ausfall bedrohte Komponente rechtzeitig vor dem Ausfall ausgetauscht werden kann.

Insbesondere bei Umrichtern, wie sie bei der Ansteuerung von Elektromotoren, beispielsweise EC (Electronically Commutated)-Motoren, zum Einsatz kommen, sind mehrere lebensdauerbegrenzende Bauteile und Baugruppen vorhanden. Am stärksten von einem Ausfall bedroht sind meist Halbleiter (vornehmlich in der Endstufe oder in Optokopplern) und Kondensatoren (vornehmlich bei Elektrolytkondensatoren im Zwischenkreis oder in Schaltnetzteilen). Insbesondere Kondensatoren unterliegen einer starken temperatur- und laststromabhängigen Alterung, weswegen die Lebensdauer stark variieren kann.

Die JPH7-92213A offenbart ein Verfahren, das den Ablauf der Lebensdauer eines Kondensators abschätzen lässt. Hierzu wird die interne Temperatur $T_c$ des Kondensators mit der Formel $T_c = T_0 + K(I_c/I_s)$ geschätzt. Dabei sind $T_0$ die Umgebungstemperatur, $I_c$ der Strom durch den Kondensator und $I_s$ der zulässige Ripple-Strom.

K ist ein Skalierungsfaktor, der von dem Typ des Kondensators abhängig ist. Alle geschätzten $T_c$ werden aufsummiert. Wenn die Summe einen vorgegebenen Wert überschreitet, wird für den Ablauf der Lebensdauer entschieden. Nachteilig an diesem Verfahren ist, dass der aktuelle Wert der Summe von einer Vielzahl von Summanden abhängt. Dadurch pflanzen sich Fehler, insbesondere Mess- oder Quantisierungsfehler, erheblich fort.

Aus der DE 10 2012 105 198 A1 ist ein Verfahren zur Lebensdauerüberwachung bekannt, mit dem die Restlebensdauer eines Elektrolytkondensators abgeschätzt werden kann. Die Berechnungen basieren im Wesentlichen auf der hinlänglich bekannten Formel:

$$L_x = L_0 \cdot 2^{\frac{T_0 - T_x}{10}} \cdot 2^{\frac{\Delta T_m - \Delta T_m \left( I_{ripple} / I_0 \right)^2}{k}}$$

Dabei sind:

$L_x$      die zu erwartende aktuelle Lebensdauer,
$L_0$      spezifizierte Lebensdauer gemäß Datenblatt,
$T_0$      eine vorbestimmte maximale Betriebstemperatur (z.B. 105 °C),
$T_x$      die jeweils aktuelle Umgebungstemperatur,
$\Delta T_m$      eine Konstante, sog. Inside Temperature Increase,
$I_{ripple}$      aktueller Ripplestrom am Zwischenkreiskondensator,
$I_0$      spezifizierter Ripplestrom gemäß Datenblatt und
$k$      eine Konstante, sog. Beschleunigungsfaktor.

Nachteilig an diesem Verfahren ist, dass kontinuierlich Werte aufgezeichnet und berechnet werden müssen. Dabei geben die komplexen und aufwändigen Berechnungen lediglich eine statistische Ausfallwahrscheinlichkeit an, ohne auf den tatsächlichen Zustand eingehen zu können.

Die EP 1 338 874 A1 bestimmt die Restlebensdauer eines Elektrolytkondensators auf ähnliche Weise. Basis ist hier eine etwas vereinfachte Form der voranstehenden Formel. Dabei ist ein starker Fokus auf die Ermittlung der Kondensator-Temperatur gelegt.

Bei der DE 10 2004 035723 A1 wird davon ausgegangen, dass eine Verdunstung von Elektrolytflüssigkeit des Kondensators zur Alterung des Kondensators führt und dass die Höhe der Kerntemperatur bei dem Grad der Verdunstung entscheidend ist. Daher wird mit einem thermischen Modell, das im Wesentlichen auf einer vereinfachten Form der voranstehenden Formel beruht, und weiteren Berechnungsschritten die Restlebensdauer abgeschätzt. Auch hier sind lediglich statistische Aussagen möglich.

Aus der US 2009/072982 A ist ein Verfahren zum Bestimmen des Gesundheitszustands eines Kondensators in einem Leistungsumrichter bekannt. Hierzu wird die Ripple-Spannung im Gleichspannungszwischenkreis überwacht und mit einem initialen Wert der Ripple-Spannung verglichen. Aufgrund einer sinkenden Kapazität des Elektrolyt-Kondensators infolge von Alterung wird eine vorhandene Ripple-Spannung weniger stark ausgefiltert. Aus dem Ausmaß vorhandener Ripple wird auf den Zustand des Kondensators geschlossen. Nachteilig daran ist, dass die Filtereigenschaft des Zwischenkreiskondensators zwar erheblich zur Reduzierung der Ripple beiträgt, die Ausprägung der Ripple aber nicht alleine von der Kapazität des Zwischenkreiskondensators, sondern von weiteren Faktoren abhängt.

Für die Zustandsbestimmung einer Kapazität offenbart die US 2009/0088993 A1 einen kondensatorbasierten Hilfsenergiespeicher für ein Fahrzeug, der sicherheitsrelevante Systeme, wie die Bremsanlage, bei Ausfall der Batterie kurzfristig weiterversorgen und damit ein sicheres Anhalten des Fahrzeugs ermöglichen kann. Während eines Ladevorgangs der Kondensatoreinheit mit konstantem Strom wird eine Spannungsänderung über der Kondensatoreinheit und eine zugehörige Ladezeit gemessen. Daraus wird die aktuelle Kapazität C der Kondensatoreinheit errechnet. Während des Ladevorgangs wird eine kurze Ladeunterbrechung eingeschoben, aus der auf den Innenwiderstand R der Kondensatoreinheit geschlossen wird. Statt des Ladevorgangs kann auch ein Entladevorgang genutzt werden. Zusätzlich wird die aktuelle Temperatur der Kondensatoreinheit gemessen. Für die aktuelle Temperatur wird ein Normalwert $C_{nor}$ bzw. $R_{nor}$ aus einer Look-up-Tabelle geladen, die temperaturabhängige Werte der Kapazität und des Innenwiderstands einer neuen Kondensatoreinheit gleichen Typs enthält. Wenn die gemessene Kapazität C kleiner als ein Grenzwert $C_{lim}$ ist oder wenn der gemessene Innenwiderstand R größer als ein Grenzwert $R_{lim}$ ist, wird für eine Degradation der Kondensatoreinheit entschieden und ein Degradationssignal ausgegeben, wobei die Grenzwerte abhängig von den Normalwerten gewählt sind. Es werden verschiedene weitere Auswertungen durchgeführt, um Falschmeldungen zu vermeiden.

DE 10 2012 215 963 A1 offenbart ein Verfahren, mit dem die bisher verbrauchte Lebensdauer eines Elektrolytkondensators in einem Zwischenkreis eines Wechselrichters ermittelt werden kann. Hierzu wird der Leckstrom und/oder die reale Speicherfähigkeit des Kondensators ermittelt und bei Erreichen eines Meldewertes eine Warnung ausgegeben. Da der Leckstrom von der Kerntemperatur abhängig ist, wird mittels eines thermischen Modells aus der Umgebungstemperatur auf die Kerntemperatur geschlossen.

Ebenfalls für die Zustandsbestimmung einer Kapazität in einem Hybridfahrzeug offenbart die DE 11 2009 000 643 T5 ein Verfahren zur Zustandsbestimmung eines Kondensators, der als Zwischenspeicher in einer Hybrid-Baumaschine genutzt wird. Nach Stoppen der Baumaschine wird in einen Zustandsbestimmungsmodus geschaltet und der Kondensator mittels eines Motorgenerators definiert aufgeladen. Aus einer Ladezeit und einer Erhöhung der Spannung über dem Kondensator während des Aufladens wird die Kapazität des Kondensators berechnet. Zudem wird die Temperatur des Kondensators erfasst und mithilfe der erfassten Temperatur ein temperaturabhängiger Korrekturfaktor aus einer Tabelle geladen. Eine korrigierte Kapazität, die durch Multiplikation des Korrekturfaktors mit der berechneten Kapazität entsteht, wird mit einer anfänglichen Kapazität verglichen und eine prozentuale Abweichung ermittelt. Abhängig von der prozentualen Abweichung wird entschieden, ob der Zustand des Kondensators "OK" oder "nicht gut" ist.

Der vorliegenden Erfindung liegt die Aufgabe zugrunde, ein Verfahren, eine Bewertungseinheit und ein System der eingangs genannten Art derart auszugestalten und weiterzubilden, dass die Restlebensdauer eines Kondensators mit geringem Aufwand ermittelbar ist.

Erfindungsgemäß wird die voranstehende Aufgabe durch die Merkmale des Anspruchs 1 gelöst. Danach umfasst das in Rede stehende Verfahren die Schritte:

Messen einer Spannungsänderung über dem Kondensator während einer Entladezeit,
Bestimmen eines Entladestroms während der Entladezeit,
Ermitteln einer Istkapazität des Kondensators anhand der Spannungsänderung, des Entladestroms und der Entladezeit,
Bestimmen einer korrigierten Kapazität des Kondensators aus der Istkapazität mittels einer Fehlerkorrektur, wobei bei der Fehlerkorrektur Einflüsse der Temperatur auf die Kapazität des Kondensators korrigiert werden, und
Ermitteln der Restlebensdauer basierend auf einer Differenz zwischen der korrigierten Kapazität und einer Initialkapazität des Kondensators.

Hinsichtlich einer Bewertungseinheit ist die voranstehende Aufgabe durch die Merkmale des Anspruchs 9 gelöst. Danach umfasst die Bewertungseinheit:

einen Spannungseingang, der zum Eingeben eines Messwerts für eine Spannungsänderung über dem Kondensator während einer Entladezeit ausgebildet ist,
einen Stromeingang, der zum Eingeben eines Messwerts für den Entladestrom ausgebildet ist, wobei der Entladestrom während der Entladezeit ermittelt worden ist,
eine Kapazitätsermittlungseinheit, die zum Ermitteln einer Istkapazität des Kondensators anhand der Spannungsänderung, des Entladestroms und der Entladezeit ausgebildet ist,

eine Korrektureinheit, die zum Bestimmen einer korrigierten Kapazität aus der Istkapazität mittels einer Fehlerkorrektur ausgebildet ist, wobei bei der Fehlerkorrektur Einflüsse der Temperatur auf die Kapazität des Kondensators korrigiert werden, und

einer Auswerteeinheit, die dazu ausgebildet ist, basierend auf einer Differenz zwischen der korrigierten Kapazität und einer Initialkapazität des Kondensators die Restlebensdauer des Kondensators zu ermitteln.

Hinsichtlich eines Systems wird die voranstehende Aufgabe durch die Merkmale des Anspruchs 10 gelöst.

In erfindungsgemäßer Weise ist zunächst erkannt worden, dass auf äußerst aufwändige und/oder iterative Schätzverfahren verzichtet werden kann, um Aussagen über die Restlebensdauer eines Kondensators fällen zu können. Vielmehr ist es erfindungsgemäß sogar vergleichsweise einfach möglich, basierend auf meist ohnehin vorhandenen Messwerten eine präzise Aussage über die Restlebensdauer und/ oder das Lebensdauerende eines Kondensators zu treffen. Über die Lebensdauer eines Kondensators nehmen der Leckstrom zu und der ESR (Equivilent Series Resistance) und die Kapazität sinken. Damit kann durch Bestimmen der aktuellen Kapazität eine Aussage über die Restlebensdauer des Kondensators getroffen werden. Zwar ist die Kapazität eines Kondensators, der im laufenden Betrieb in einer Schaltung vermessen werden soll, von den jeweiligen Betriebsbedingungen abhängig, so dass eine Bewertung der Restlebensdauer auf diese Weise schwierig erscheint. Allerdings kann die Kapazität dennoch als Maß für die Restlebensdauer verwendet werden, wenn die Einflüsse des Betriebs des Kondensators durch eine Fehlerkorrektur korrigiert werden. In diesem Zusammenhang ist die Temperatur die wichtigste Größe, die Einfluss auf die Kapazität des Kondensators hat. Daher wird erfindungsgemäß ein gemessener Kapazitätswert mittels Fehlerkorrektur auf einen Referenzbetriebszustand umgerechnet. Die dadurch ermittelte korrigierte Kapazität lässt sich ohne Weiteres mit einer Initialkapazität des Kondensators vergleichen, so dass aus diesem Vergleich Rückschlüsse auf die Alterung des Kondensators gezogen werden können. Damit lässt sich wiederum die Restlebensdauer des Kondensators bestimmen.

Die Kapazität eines Kondensators kann basierend auf der Differentialgleichung

$$i = C\frac{du}{dt}$$

berechnet werden. Daraus ergeben sich sowohl im Lade- als auch im Entladezweig ein exponentieller Spannungs- und Stromverlauf. Für die Bestimmung der Kapazität könnte sowohl der Ladevorgang als auch der Entladevorgang der Kapazität genutzt werden. Aufgrund der Einflüsse des Ladestroms während des Ladevorgangs würde die Bestimmung der Kapazität während der Ladung allerdings komplexer werden. Daher wird bei dem erfindungsgemäßen Verfahren der Entladezweig genutzt.

Geht man zu einem bestimmten Zeitpunkt von einem linearen oder quasilinearen Verlauf der Entladekurve aus, vereinfacht sich die Gleichung zu:

$$I = C\frac{\Delta U}{\Delta t}$$

Daraus ergibt sich die Gleichung:

$$C = I\frac{\Delta t}{\Delta U}$$

Damit kann die Istkapazität eines Kondensators aus der Kenntnis eines Spannungsänderung $\Delta U$ während einer Entladezeit $\Delta t$ und dem dabei fließenden Entladestrom I berechnet werden.

Daher wird bei dem erfindungsgemäßen Verfahren zunächst eine Spannungsänderung $\Delta U$ über den Kondensator während einer Entladezeit $\Delta t$ gemessen. Gleichzeitig wird ein Entladestrom I während der Entladezeit $\Delta t$ bestimmt. In einem weiteren Schritt wird die Istkapazität $C_{gemessen}$ des Kondensators anhand der Spannungsänderung $\Delta U$, des Entladestroms I und der Entladezeit $\Delta t$ berechnet.

Da - wie zuvor bereits ausgeführt - die Istkapazität $C_{gemessen}$ des Kondensators von den Betriebsbedingungen des Kondensators abhängt, wird in einem nächsten Schritt eine entsprechende Fehlerkorrektur durchgeführt. Mittels dieser Fehlerkorrektur wird eine korrigierte Kapazität $C_x$ des Kondensators bestimmt, bei der mindestens eine Größe mit Einfluss auf die Kapazität des Kondensators eliminiert ist. Damit ist die korrigierte Kapazität ein Wert, der bezüglich der korrigierten Einflussgröße auf einen Referenzwert zurückgerechnet ist. Da die Temperatur des Kondensators einen wichtigen Einfluss auf die tatsächliche Kapazität des Kondensators hat, wird erfindungsgemäß die Einflussgröße "Temperatur" bei der Fehlerkorrektur korrigiert. Bei dieser Fehlerkorrektur wird die gemessene Istkapazität $C_{gemessen}$ auf eine vordefinierte Referenztemperatur transformiert. Bei welchem Wert die Referenztemperatur gewählt ist, ist weitgehend unerheblich. Voraussetzung ist, dass die Temperatur innerhalb des Betriebsbereichs des Kondensators liegt. Denkbar ist beispielsweise eine Referenztemperatur von 0 °C, 20 °C oder 30 °C, nur um einige mögliche Beispiele zu nennen. Da in Datenblättern von Kondensatoren sehr häufig eine Referenztemperatur von 20 °C verwendet wird, wird bei dem erfindungsgemäßen Verfahren vorzugsweise auf die Referenztemperatur von 20 °C zurückgerechnet.

Durch die Fehlerkorrektur entstehen damit Kapazitätswerte, die unabhängig von der aktuell existierenden Betriebsbedingung miteinander vergleichbar sind. Auf diese Weise lässt sich ein Maß bestimmen, inwieweit sich der Kapazitätswert im Laufe der bisherigen Lebensdauer des Kondensators bereits verändert hat. Hierzu wird in einem weiteren Schritt eine Differenz zwischen der korrigierten Kapazität $C_x$ und einer Initialkapazität $C_0$ des Kondensators gebildet. Die Initialkapazität $C_0$ stellt dabei den Kapazitätswert des Kondensators dar, der bei Beginn der Lebensdauer des Kondensators vorgelegen hat. Bei Kondensatoren, beispielsweise bei Elektrolytkondensatoren, ist der Kapazitätswert zu Beginn der Lebensdauer relativ konstant und sinkt gegen Ende der Lebensdauer deutlich schneller ab. Dennoch nimmt der Kapazitätswert von Elektrolytkondensatoren während der Lebensdauer kontinuierlich ab. Damit kann aus der Differenz zwischen der korrigierten Kapazität $C_x$ und der Initialkapazität $C_0$ ein Maß für die Restlebensdauer des Kondensators abgeleitet werden. Wenn sich die korrigierte Kapazität $C_x$ lediglich um wenige Prozent von der Initialkapazität $C_0$ unterscheidet, ergibt sich eine noch relativ lange Restlebensdauer. Wenn sich die korrigierte Kapazität allerdings um einen zweistelligen Prozentbetrag von der Initialkapazität unterscheidet, so droht der baldige Ausfall des Kondensators. Zum Bestimmen der Restlebensdauer kann dabei eine Lebensdauerkennlinie des Kondensators verwendet werden. Auch wenn es Exemplarstreuungen der Lebensdauern von Kondensatoren geben wird, so kann auf diese Weise dennoch ein recht präzises Bild über die zu erwartende Restlebensdauer gewonnen werden.

Prinzipiell ist es für das erfindungsgemäße Verfahren unerheblich, welcher Typ der Kondensator aufweist. Wesentlich ist jedoch, dass die Kapazität des Kondensators in Bezug auf eine Initialkapazität eine stetige Veränderung über die Lebensdauer des Kondensators erfährt. Dabei ist es besonders günstig, wenn der Kapazitätswert gegen Ende der Lebensdauer stärker abfällt als zu Beginn der Lebensdauer. Dadurch kann nämlich besonders genau das Erreichen des Lebensdauerendes erkannt werden. In besonders bevorzugter Weise wird das erfindungsgemäße Verfahren jedoch im Zusammenhang mit der Bestimmung der Restlebensdauer von Elektrolytkondensatoren verwendet.

Das erfindungsgemäße Verfahren bietet die Möglichkeit, einen Kondensator im laufenden Betrieb zu bewerten. In welcher Art von Schaltung der zu bewertende Kondensator verbaut ist, ist dabei von untergeordneter Bedeutung. Wesentlich ist lediglich, dass der Kondensator während des Betriebs der Schaltung zumindest einmalig geladen und entladen wird. Dieses zumindest einmalige Laden und Entladen muss während des Ermittelns der Istkapazität erfolgen. Zum Vereinfachen der Ermittlung der Restlebensdauer ist es günstig, wenn der Kondensator - in einer bevorzugten Weiterbildung - wiederholt geladen und entladen wird, da dann ein wiederholtes Ermitteln der Restlebensdauer möglich ist. Ganz besonders günstige Verhältnisse liegen vor, wenn der Kondensator - in einer ganz besonders bevorzugten Weiterbildung - periodisch aufgeladen und entladen wird, da dann das Auslösen der Messungen und/oder Berechnungen besonders einfach ist. Dabei muss der Kondensator nicht vollständig geladen oder vollständig entladen werden. Wesentlich ist lediglich, dass eine zumindest partielle Ladung und Entladung des Kondensators erfolgt. Insbesondere mit Blick auf eine besonders einfache Berechnung im linearen bzw. quasilinearen Bereich des Kondensators ist es sogar günstig, wenn lediglich eine partielle Entladung des Kondensators erfolgt.

In besonders bevorzugter Weise kommt das erfindungsgemäße Verfahren jedoch in einer Schaltung zum Einsatz, die einen Gleichspannungszwischenkreis aufweist, wobei der zu bewertende Kondensator dann in dem Zwischenkreis als Pufferkondensator eingesetzt würde. Eine derartige Schaltung mit einem Gleichspannungszwischenkreis kann beispielsweise durch eine Wechselrichterschaltung gebildet sein, die an einem Energieversorgungsnetzwerk mit einer Wechselspannung betrieben wird und am Ausgang eine Wechselspannung ausgibt. Derartige Wechselrichter werden beispielsweise bei dem Betrieb eines Elektromotors verwendet. Eine ganz besonders bevorzugte Schaltung mit Zwischenkreis ist dabei ein Umrichter für einen EC-Motor.

Auch wenn voranstehend von der Bestimmung der Kapazität eines Kondensators die Rede ist, so lässt sich das erfindungsgemäße Verfahren auch für eine Verschaltung von Kapazitäten verwenden. Dabei ist es unerheblich, ob die Kapazitäten parallel oder/und in Reihe geschaltet sind. Bei derartigen Verschaltungen mehrerer Kapazitäten würde dann die Summenkapazität der Kondensatoren ausgewertet. Wichtig hierbei ist lediglich, dass sich die Kondensatoren im Laufe der Lebensdauer in ähnlicher Weise verändern, beispielsweise eine vergleichbare Reduktion der Kapazität erfahren. Ferner sollten die Kondensatoren in ähnlicher Weise belastet sein, insbesondere ähnlichen Temperaturen ausgesetzt sein. In einem derartigen Fall würde durch das erfindungsgemäße Verfahren die Restlebensdauer der Verschaltung der Kondensatoren bestimmt. Als Initialkapazität, mit der eine korrigierte Gesamtkapazität verglichen wird, würde dann die Kapazität dienen, die die verschalteten Kapazitäten bei Inbetriebnahme zu Beginn der Lebensdauer aufweisen.

Da die Restlebensdauer des Kondensators von dessen jeweiligen Betriebsbedingungen abhängen wird, kann bei der Berechnung der Restlebensdauer von verschiedenen Annahmen ausgegangen werden. Denkbar ist beispielsweise, die aktuell vorhandenen Betriebsbedingungen zu extrapolieren. Damit wäre eine Aussage möglich: Wenn der Kondensator mit den aktuell vorhandenen Bedingungen weiterbetrieben wird, ist ein Ausfall in x Stunden zu erwarten. Denkbar ist aber auch, die Restlebensdauer basierend auf einem Durchschnitt der Betriebsbedingungen in der vergangenen Zeit, beispielsweise in den vorangegangenen 7 Tagen, zu extrapolieren. Denkbar ist aber auch, von Referenzbedingungen für den Betrieb des Kondensators auszugehen. Der letztgenannte Ansatz hat insbesondere dahingehend Vorteile, dass die Restlebensdauer nicht weiter angepasst werden muss.

Neben der Temperatur haben auch andere Einflüsse während des Betriebs eine Auswirkung auf die Istkapazität eines Kondensators. Derartige Einflüsse sind beispielsweise die Frequenz des Laststroms während des Messzeitraums, die Höhe der Spannung über dem Kondensator während des Messzeitraums (Ripple der Spannung können meist vernachlässigt werden, insbesondere bei einer partiellen Entladung des Kondensators) und die Höhe des Laststroms während des Messzeitraums. Daher wird in einer Weiterbildung der Erfindung neben der Temperatur noch der Einfluss mindestens einer dieser weiteren Einflüsse korrigiert. Zum Erreichen einer besonders präzise korrigierten Kapazität können dabei alle vier vorgenannten Einflussgrößen in einer Fehlerkorrektur korrigiert werden.

Die Art der Abhängigkeit der Kapazität eines Kondensators hängt meist von dem Typ des Kondensators und dem konkreten internen Aufbau des Kondensators ab. Dabei verhalten sich alle Exemplare eines bestimmten Modells eines Kondensators in ähnlicher Weise, wenn sie einer verändernden Einflussgröße ausgesetzt sind. Daher wird in einer anderen Weiterbildung die Fehlerkorrektur bzw. die Fehlerkorrekturen anhand einer Kennlinie des Kondensators durchgeführt. Eine derartige Kennlinie kann üblicherweise dem Datenblatt des Kondensators entnommen werden. Alternativ kann diese Kennlinie auch exemplarisch für einen Kondensator einer Bauart erstellt werden. Für die Fehlerkorrektur kann dabei die Kennlinie in verschiedenster Form abgespeichert sein. Denkbar wäre beispielsweise, eine Wertetabelle für die Kennlinie bereitzustellen, wobei eventuell zwischen zwei Werten der Tabelle liegende Werte interpoliert würden. Zum Erzielen eines besonders effizienten Verfahrens wird die Kennlinie des Kondensators jedoch vorzugsweise durch mehrere Teilabschnitte approximiert. Da die Kennlinien üblicherweise relativ einfach verlaufen, lässt sich eine Approximation in zwei bis drei Teilabschnitten sehr gut verwirklichen. Dabei gehen die Teilabschnitte vorzugsweise stetig ineinander über. In ganz besonders bevorzugter Weise sind die Teilabschnitte dabei durch Polynome erster und zweiter Ordnung beschreibbar. Auf diese Weise lässt sich eine Berechnungsvorschrift für die Fehlerkorrektur sehr effizient abspeichern und die Berechnung der korrigierten Kapazität lässt sich sehr einfach durchführen.

Auch bezüglich der Lebensdauerkennlinie, die bei der Bestimmung der Restlebensdauer zum Einsatz kommen kann, kann eine (abschnittsweise) approximierte Kennlinie verwendet werden. Dadurch lässt sich die Berechnung erheblich vereinfachen.

Für das Bestimmen der Temperatur des Kondensators lassen sich verschiedenste Verfahren einsetzen. So ist es denkbar, die Temperatur des Kondensators direkt an dem Kondensator zu messen. Dies kann durch ein Sensorelement, das im direkten Kontakt mit dem Kondensator steht, erfolgen. Alternativ wäre auch denkbar, einen Temperatursensor in den Kondensator zu integrieren. Vorzugsweise wird jedoch eine Umgebungstemperatur des Kondensators gemessen und auf die Temperatur des Kondensators zurückgerechnet. Es ist nämlich relativ gut bekannt, wie sich die Temperatur innerhalb eines Kondensators bei einer bekannten Belastung und einer bekannten Umgebungstemperatur verhält. Für die Abschätzung der Temperatur des Kondensators basierend auf der Umgebungstemperatur des Kondensators kann dabei die Spannung über dem Kondensator, der Entladestrom durch den Kondensator und/oder die Frequenz des Entladestroms verwendet werden. Auf diese Weise lässt sich relativ genau die Temperatur des Kondensators abschätzen, ohne einen dedizierten Temperatursensor in dem Kondensator zu erfordern. Dabei kann auf verschiedene Temperaturen zurückgerechnet werden, beispielsweise die Durchschnittstemperatur des Kondensators oder die Kerntemperatur. Welche Temperatur hierbei verwendet wird, hängt im Wesentlichen damit zusammen, bezüglich welcher Temperatur die Fehlerkorrektur durch die Temperatureinflüsse durchgeführt wird. Wenn beispielsweise die für eine Fehlerkorrektur herangezogene Kennlinie des Kondensators auf der Durchschnittstemperatur des Kondensators basiert, so sollte auch die gemessene oder zurückgerechnete Temperatur die Durchschnittstemperatur des Kondensators sein.

Die Entscheidung, wann das Lebensdauerende eines Kondensators naht oder erreicht ist, hängt von verschiedenen Faktoren ab. Zu diesen Faktoren gehört beispielsweise der Typ des Kondensators, der Aufbau des Kondensators oder der Mindestkapazitätswert, den der Kondensator in der ihn umgebenden Schaltung mindestens aufweisen muss. Daher wird zum Entscheiden für ein Lebensdauerende vorzugsweise ein vorgebbarer Anteil verwendet, um den die korrigierte Kapazität unter die Initialkapazität abgesunken ist. Dieser vorgebbare Wert ist vorzugsweise auf einen Wert zwischen 15% und 50% gesetzt. Ganz besonders bevorzugter Weise ist der vorgebbare Anteil zwischen 15% und 30% gewählt. In einer ganz besonders bevorzugten Ausgestaltung ist der vorgebbare Anteil bei 20% gewählt.

Die Wahl der Entladezeit für die Messung einer Spannungsänderung ist ebenso von verschiedenen Faktoren abhängig. Wichtig für die Wahl der Entladezeit ist, dass im Wesentlichen kein Ladestrom in den Kondensator fließt und damit keine nennenswerte Aufladung des Kondensators erfolgt. Daher sollte die Entladezeit $\Delta t$ ausreichend klein gewählt sein, damit die Messung rechtzeitig vor dem Start der nächsten periodischen Aufladung abgeschlossen ist. Wenn beispielsweise der Kondensator in einem Gleichspannungszwischenkreis angeordnet ist, so sind die Ladephasen von der Frequenz der am Eingang der Schaltung anliegenden Wechselspannung abhängig. Die Entladezeit $\Delta t$ sollte daher klein gegenüber der Frequenz der Eingangsspannung gewählt werden. Denkbar wäre beispielsweise, dass $\Delta t$ kleiner als 20% der Periodenlänge der Eingangsspannung ist. Zur Vereinfachung der Berechnung der Istkapazität wird vorzugsweise die Entladezeit $\Delta t$ zusätzlich derart gewählt, dass der Kondensator während der Entladezeit $\Delta t$ quasilinear entladen wird. Wenn der Kondensator eine Zwischenkreiskapazität ist, ist dies üblicherweise in einem weiten Bereich der Entladephase gegeben. Daher kann diese Weiterbildung insbesondere bei Schaltungen mit einem Gleichspannungszwischenkreis besonders einfach implementiert werden.

Auch für die Bestimmung der Spannungsänderung über den Kondensator während der Entladezeit sind verschiedene Implementierungen denkbar. Vorzugsweise wird die Spannung über den Kondensator jeweils zu Beginn der Entladezeit $\Delta t$ und am Ende der Entladezeit $\Delta t$ gemessen und aus diesen beiden Spannungswerten die Spannungsänderung $\Delta U$ berechnet. Insbesondere bei Umrichtern ist die Spannung über dem Kondensator, nämlich die Zwischenkreisgleichspannung, bereits bekannt, da diese Spannung für die Regelung der Leistungsstufe benötigt wird. Insofern lassen sich insbesondere bei der Verwendung des erfindungsgemäßen Verfahrens bei einem Umrichter besonders einfach die Spannungswerte und damit die Spannungsänderung $\Delta U$ bestimmen.

Zum weitgehenden Ausschließen von Randeffekten bei der Ermittlung der Initialkapazität empfiehlt es sich, die Initialkapazität bei einer ersten Inbetriebnahme des Kondensators bzw. der den Kondensator umgebenden Schaltung zu ermitteln. Dabei wird vorzugsweise wie beim Bestimmen der korrigierten Kapazität vorgegangen. Dies bedeutet, dass auch hier eine Spannungsänderung $\Delta U$ gemessen, der Entladestrom I bestimmt und daraus zusammen mit der gewählten Entladezeit $\Delta t$ eine Istkapazität $C_{gemessen}$ ermittelt wird. Anschließend erfolgt eine Fehlerkorrektur, die zumindest die Temperatur des Kondensators berücksichtigt. Zum Erzielen einer besonders präzisen Initialkapazität empfiehlt es sich noch weitere Einflussgrößen in die Fehlerkorrektur einfließen zu lassen. Dabei ist es auch denkbar, dass zur Beseitigung eventueller Messfehler das Ermitteln der Initialkapazität mehrmals durchgeführt wird und dass ein Mittelwert aus den mehreren ermittelten Werten für die Initialkapazität gebildet und als Wert der Initialkapazität $C_0$ abgespeichert wird. Auf diese Weise würden sich die Einflüsse von Messfehlern reduzieren. Ferner ist denkbar, dass das Ermitteln der Initialkapazität erst nach Ablauf einer Burn-in-Periode durchgeführt wird, d.h. dass die Schaltung, in der der Kondensator angeordnet ist, für eine Burn-In-Periode, beispielsweise 10 Stunden, betrieben wird und dass erst danach die Initialkapazität ermittelt wird.

Das erfindungsgemäße Verfahren kann durch eine erfindungsgemäße Bewertungseinheit ausgeführt werden. Diese Bewertungseinheit umfasst zumindest einen Spannungseingang, einen Stromeingang, eine Kapazitätsermittlungseinheit, eine Korrektureinheit und eine Auswerteeinheit. Der Spannungseingang ist dazu ausgebildet, dass ein Messwert für eine Spannungsänderung $\Delta U$ über dem Kondensator während einer Entladezeit $\Delta t$ eingegeben wird. Diese Spannungsänderung kann auf verschiedenste Weise gebildet sein, wozu auf die vorangehenden Ausführungen verwiesen wird. Der Stromeingang ist derart ausgebildet, dass ein Messwert für den Entladestrom, der während der Entladezeit $\Delta t$ ermittelt worden ist, eingegeben wird. Die Kapazitätsermittlungseinheit ist dazu ausgebildet, eine Istkapazität des Kondensators anhand der Spannungsänderung $\Delta U$, des Entladestroms I und der Entladezeit $\Delta t$ zu ermitteln. Die Korrektureinheit führt die Fehlerkorrektur ausgehend von der Istkapazität durch und bestimmt auf diese Weise eine korrigierte Kapazität $C_x$. Die Auswerteeinheit ermittelt aus einer Differenz zwischen der korrigierten Kapazität $C_x$ und einer Initialkapazität $C_0$ des Kondensators eine Restlebensdauer $L_r$ des Kondensators. Dieses Maß für die Restlebensdauer des Kondensators, das durch die Auswerteeinheit ermittelt wird, kann auf verschiedenste Weise weiterverwendet werden. Denkbar ist das Erzeugen eines Warnsignals, wenn die Differenz einen vorgebbaren Wert überschreitet. Denkbar ist aber auch, diesen Wert für eine weitere Bearbeitung abzuspeichern, beispielsweise zum Erzeugen eines zeitlichen Verlaufs oder zum Zugriff auf den Wert bis zur Berechnung eines aktualisierten Werts. Vorzugsweise weist jedoch die Bewertungseinheit einen Ausgang auf, über den das durch die Bewertungseinheit ermittelte Maß für die Restlebensdauer ausgebbar ist.

Die Bewertungseinheit und deren Elemente können auf verschiedenste Art und Weise implementiert sein. In den meisten Fällen wird eine Implementierung jedoch durch eine Kombination von Soft- und Hardware erfolgen. Dies kann beispielsweise bedeuten, dass die Kapazitätsermittlungseinheit durch Programmcode implementiert ist, der auf einem Mikrocontroller oder einem anderen Prozessor abgearbeitet wird. Selbst der Spannungseingang oder der Stromeingang kann durch Software implementiert sein, beispielsweise durch eine Speicherstelle, in die die entsprechenden Spannungs- bzw. Stromwerte abgelegt werden. Entsprechende Implementierungen sind in der Praxis bekannt.

Die Bewertungseinheit kann in einem System aus einer Schaltung und Bewertungseinheit angeordnet sein. Diese Schaltung würde mindestens einen Kondensator umfassen, dessen Restlebensdauer durch die Bewertungseinheit bestimmt werden soll. Dieser Kondensator wird im Betrieb der Schaltung zumindest einmalig aufgeladen und entladen. Auch hier sei darauf hingewiesen, dass keine vollständige Aufladung und Entladung vorliegen muss, vielmehr kann und wird üblicherweise eine partielle Entladung erfolgen, so dass stets eine gewisse Restladung während des Betriebs der Schaltung in dem Kondensator verbleibt. Ferner sei darauf hingewiesen, dass für das Ermitteln der Restlebensdauer des Kondensators prinzipiell eine einmalige Ladung und Entladung des Kondensators ausreichen würde. Vorzugsweise wird der Kondensator aber wiederholt geladen und entladen, so dass eine wiederholte Ermittlung der Restlebensdauer möglich wird. Besonders bevorzugter Weise wird der Kondensator sogar periodisch aufgeladen und entladen.

In einer bevorzugten Ausgestaltung dieser Schaltung umfasst die Schaltung einen Gleichspannungszwischenkreis, in dem der mindestens eine Kondensator als Pufferkondensator zum Einsatz kommt. In einer Weiterbildung des erfindungsgemäßen Systems umfasst dieses eine Zwischenkreisüberwachung, die die Spannung über dem Kondensator misst und an den Spannungseingang der Bewertungseinheit eingibt. Dabei ist die gemessene Spannung über dem Kondensator vorzugsweise die im Zwischenkreis anliegende Gleichspannung.

Für das Bestimmen des Entladestroms I kann in einer Weiterbildung des Systems eine Stromermittlungseinheit vorgesehen sein. Diese Stromermittlungseinheit kann einen Stromsensor zum Messen des Entladestroms umfassen, der unmittelbar den fließenden Entladestrom misst. Allerdings ist auch denkbar, dass die Stromermittlungseinheit den Entladestrom aus weiteren Messwerten, die bereits innerhalb der Schaltung vorhanden sind, berechnet. Wenn die Schaltung beispielsweise eine Wechselrichterschaltung ist, so ist vielfach die von der Schaltung abgegebene Leistung bereits bekannt. Aus dieser abgegebenen Leistung sowie dem dann vorhandenen Spannungswert an dem Kondensator kann der Entladestrom berechnet werden. Dabei dürfte - insbesondere bei einer Messung im quasilinearen Bereich der Entladung - ein RMS-Wert (Root Mean Square) für die Leistung und die Spannung verwendet werden. Auf diese Weise kann der Entladestrom ohne zusätzliche Sensoren ermittelt werden.

Zum Messen einer Frequenz des Entladestroms kann das System eine Frequenzermittlungseinheit aufweisen. Auch hier kann die Frequenz des Entladestroms aus bereits in der Schaltung vorhandenen Werten abgeleitet werden. So könnte die Frequenzermittlungseinheit die Frequenz des Ladestroms aus einer Frequenz eines Ansteuersignals für eine Leistungsstufe der Schaltung ableiten. Insbesondere bei Wechselrichtern sind die Frequenzen eines Ansteuersignals bereits bekannt.

Das System kann zusätzlich eine Ausgabeeinheit aufweisen, über die Informationen über die ermittelte Restlebensdauer ausgegeben werden können. In einer besonders einfachen Ausgestaltung kann die Ausgabeeinheit aus einer Signalleuchte, beispielsweise einer LED (Light Emitting Diode), bestehen. Die Signalleuchte würde dann aktiviert, wenn die Restlebensdauer erreicht wird. Allerdings ist auch denkbar, dass die Ausgabeeinheit konkrete Werte, beispielsweise eine Prozentzahl, ausgibt.

Es gibt nun verschiedene Möglichkeiten, die Lehre der vorliegenden Erfindung in vorteilhafter Weise auszugestalten und weiterzubilden. Dazu ist einerseits auf die den nebengeordneten Ansprüchen nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen

Fig. 1    ein Diagramm mit typischen Spannungsverläufen an einem zu bewertenden Kondensator in einem Gleichspannungszwischenkreis,

Fig. 2    ein Diagramm mit einem Stromverlauf bei einer Spannungsbeaufschlagung entsprechend Fig. 1,

Fig. 3    ein Diagramm mit einer Approximation einer Kennlinie eines Kondensators bezüglich der Änderung der Kapazität durch die Temperatur,

Fig. 4    ein Diagramm mit einer Lebensdauerkennlinie eines Kondensators,

Fig. 5    ein Flussdiagramm mit einem beispielhaften Ablauf zum Erzeugen einer abschnittsweise approximierten Kennlinie eines Kondensators und

Fig. 6    ein Flussdiagramm eines Ausführungsbeispiels eines erfindungsgemäßen Verfahrens.

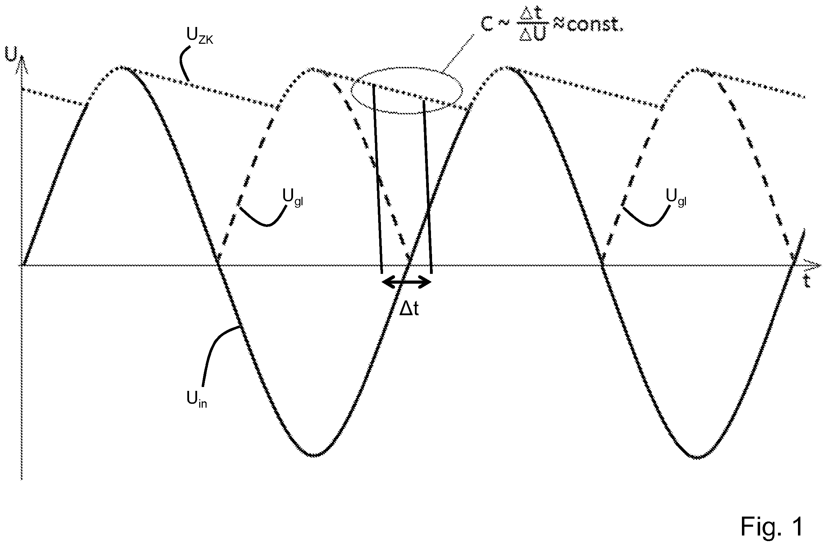

Fig. 1 zeigt ein Diagramm mit typischen Spannungsverläufen, wie sie an einem Kondensator in einem Gleichspannungszwischenkreis auftreten können. Dargestellt ist ein Anwendungsfall, bei dem eine einphasige Wechselspannung am Eingang der Schaltung durch einen Brückengleichrichter gleichgerichtet wird. Als durchgezogene sinusförmige Linie ist der Verlauf der Eingangsspannung $U_{in}$ dargestellt. Durch Gleichrichtung der Eingangsspannung werden die im negativen Bereich der Spannung dargestellten Spannungen zu positiven Spannungen umgewandelt, was durch gestrichelte Sinushalbbögen in Fig. 1 eingezeichnet ist. Diese pulsierende, gleichgerichtete Spannung $U_{gl}$ wird auf einen Kondensator aufgeschaltet. Sobald die aufgeschaltete Spannung den aktuellen Spannungswert über dem Kondensator überschreitet, fließt ein Ladestrom in den Kondensator, der den Kondensator auflädt. Sobald die gleichgerichtete Sinusspannung eine Spannung unterhalb der Spannung über dem Kondensator annehmen würde, wird der Kondensator nach und nach entladen. Der daraus resultierende Spannungsverlauf $U_{ZK}$ ist durch eine punktierte Linie dargestellt. Die Entladung des Kondensators erfolgt gemäß einer Exponentialfunktion, wobei die Entladekurve zu Beginn der Entladung einen annähernd linearen Verlauf annimmt. In diesem Bereich wird die Entladezeit Δt gewählt, während der die Spannungsdifferenz ΔU gemessen wird. Der Bereich, in dem dies gut möglich ist, ist mit einer Ellipse in Fig. 1 dargestellt. In diesem Bereich ist die Kapazität proportional zu Δt/ΔU und annähernd konstant. Eine mögliche Entladezeit für die Ermittlung der Istkapazität ist beispielhaft mit Δt eingezeichnet. Es wird die Spannung zu Beginn der Entladezeit Δt und am Ende der Entladezeit Δt gemessen und daraus eine Spannungsdifferenz ΔU ermittelt.

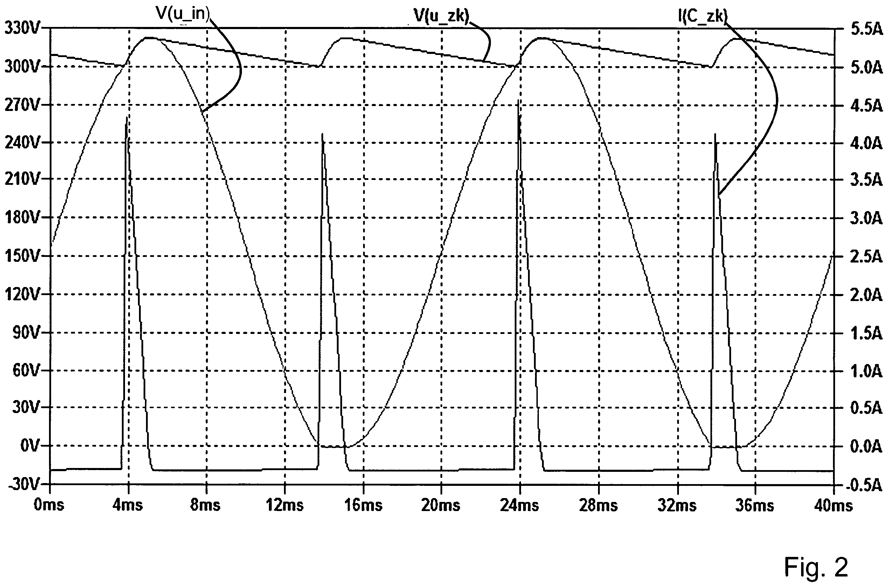

In Fig. 2 ist ein Verlauf eines beispielhaften Stroms I(C_ZK) dargestellt. Zusätzlich ist in Fig. 2 die Eingangsspannung $U_{in}$ und die Spannung über dem Kondensator $U_{ZK}$ eingezeichnet. Es ist zu erkennen, dass der Strom während der Ladephasen kurz ansteigt und ansonsten annähernd konstant bei ca. -0,3 A verläuft. D.h. bei den kurzen Stromspitzen wird der Kondensator geladen, während der Kondensator bei den annähernd horizontalen Bereichen entladen wird (in diesem Beispiel über eine ohmsche Last).

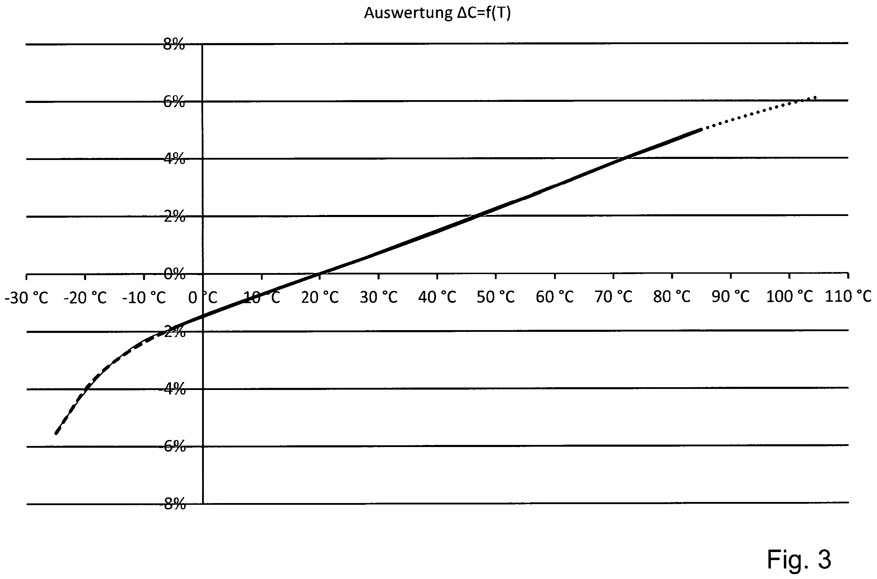

Fig. 3 stellt einen beispielhaften Verlauf einer Kapazitätsänderung über der Temperatur dar. Als Referenztemperatur ist die Temperatur von 20 °C gewählt. Mit steigender Temperatur steigt auch die Kapazität, während mit sinkender Temperatur die Kapazität ebenfalls sinkt. Bei einer Temperatur von ca. 70 °C würde beispielsweise der Kapazitätswert um knapp 4% über dem Kapazitätswert bei 20 °C ansteigen. Die in Fig. 3 dargestellte Temperaturkennlinie des Kondensators ist durch drei Teilabschnitte approximiert. Ein erster Teilabschnitt verläuft von -25°C bis -5 °C, ein zweiter Teilabschnitt zwischen -5 °C bis +85 °C und ein dritter Teilabschnitt oberhalb von +85 °C. Der erste Teilabschnitt ist durch eine gestrichelte Linie, der zweite Teilabschnitt durch eine durchgezogene Linie und der dritte Teilabschnitt durch eine punktierte Linie dargestellt. Der erste und der dritte Teil ist dabei durch ein Polynom zweiten Grades beschreibbar, während der zweite Teil durch ein Polynom ersten Grades beschrieben werden kann. Mit der in Fig. 3 dargestellten beispielhaften Kennlinienapproximation könnte beispielsweise die um den Einfluss der Temperatur korrigierte Kapazität in dem ersten Teilabschnitt durch die Formel

$$C_{x,T,-25°C...-5°C} = \left(1 - 7 \cdot 10^{-5} \cdot T^2 - 2 \cdot 10^{-4} \cdot T - 0,0186\right) \cdot C_{gemessen}$$

und in dem zweiten Teilabschnitt durch die Formel

$$C_{x,T,-5°C...+85°C} = \left(1 + 8 \cdot 10^{-4} \cdot T - 0,0151\right) \cdot C_{gemessen}$$

berechnet werden. Da der dritte Teilbereich oberhalb von +85 °C wegen einer sehr raschen Alterung des Kondensators meist irrelevant ist, wird hier auf eine formelmäßige Beschreibung verzichtet. Es ist erkennbar, dass durch diese Approximation rasch und mit geringem Aufwand eine um den Temperatureinfluss korrigierte Kapazität berechnet werden kann. Auf diese Weise wird bei einer gegebenen Temperatur eine gemessene Kapazität auf einen Referenztemperaturwert, hier 20 °C, korrigiert werden. Die derart korrigierte Kapazität ist dann durch den Einfluss der Temperatur korrigiert.

Wenn ergänzend eine Fehlerkorrektur nach anderen Einflussgrößen vorgenommen werden soll, so kann dies entsprechend erfolgen. Auch diese ergänzende Fehlerkorrektur kann jeweils mittels abschnittweise beschriebener Kennlinien erfolgen. Bei einer derartigen ergänzenden Fehlerkorrektur würde dann der im vorhergehenden Korrekturschritt berechnete Kapazitätswert in die Berechnung einfließen. Nach allen durchgeführten Fehlerkorrekturschritten würde dann die korrigierte Kapazität $C_x$ entstehen.

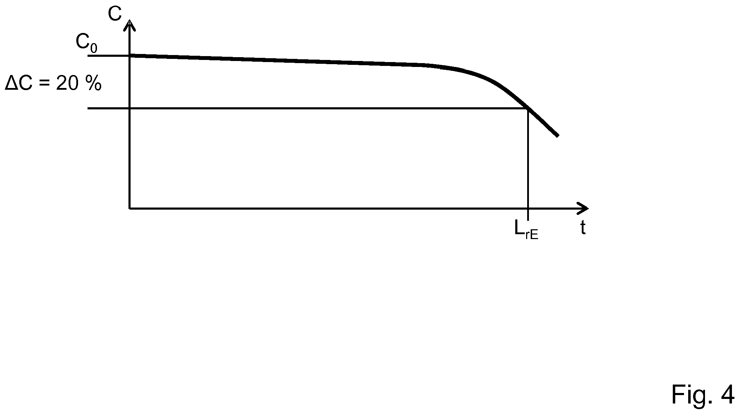

In Fig. 4 ist ein Diagramm mit einer Lebensdauerkennlinie eines Kondensators dargestellt. Auch hier kann eine (abschnittsweise) approximierte Kennlinie vorliegen. Die Anfangskapazität beträgt $C_0$ und reduziert sich im Laufe der Betriebsdauer des Kondensators. Dabei wird angenommen, dass der Kondensator stets mit ähnlichen Umgebungsbedingungen betrieben wird. Wenn der Kondensator derart betrieben wird, dass die Betriebsbedingungen zu einer verstärkten Alterung führen, beispielsweise im Bereich mit hoher Temperatur des Kondensators, so würde die Kennlinie in die Zeitrichtung t verkürzt. Bei weniger alterungserzeugenden Betriebsbedingungen würde die Kennlinie in die Zeitrichtung t gestreckt. Es ist zu erkennen, dass sich die Kapazität über eine relativ lange Zeit der Lebensdauer kaum reduziert. Erst in dem letzten Viertel der Lebensdauer sinkt die Kapazität erheblich ab. Es ist aber auch zu erkennen, dass sich die Kennlinie kontinuierlich und stetig nach unten zu geringeren Kapazitätswerten bewegt. Wenn das Lebensdauerende $L_{rE}$ über ein Absinken der Istkapazität um 20% unter die Initialkapazität $C_0$ definiert ist, ergibt sich ein Lebensdauerende $L_{rE}$ wie es in Fig. 4 eingezeichnet ist. Damit kann durch das erfindungsgemäße Verfahren zu jedem Zeitpunkt eine Aussage über die Restlebensdauer $L_r$ getroffen werden. Der einzige Wert, der zusätzlich zu den aktuellen Messwerten zwingend bekannt sein muss, ist die Initialkapazität $C_0$. Damit ist ersichtlich, dass kein iteratives Verfahren und keine komplexe Berechnungen erforderlich sind.

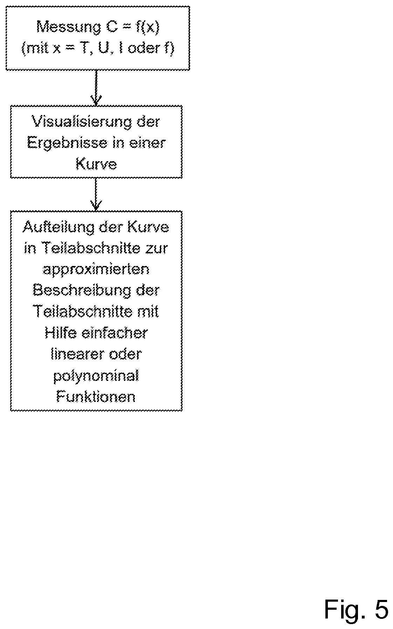

Fig. 5 zeigt ein Flussdiagramm mit einem beispielhaften Ablauf zum Erzeugen einer abschnittsweise approximierten Kennlinie eines Kondensators. In einem ersten Schritt wird die Kapazität des Kondensators in Abhängigkeit der Temperatur T, der Spannung U, des Stroms I oder der Frequenz f gemessen. Hierzu wird die Größe, deren Abhängigkeit bestimmt werden soll, kontinuierlich oder in diskreten Schritten verändert, während die anderen Größen annähernd konstant gehalten werden. Dabei bietet es sich an, die anderen Größen auf einem vordefinierten Referenzwert zu halten. Wenn beispielsweise eine Kennlinie für die Abhängigkeit der Kapazität von der Temperatur gemessen werden soll, wird die Temperatur verändert und die Spannung U, der Strom I und die Frequenz f weitgehend konstant gehalten. Die Änderung der Temperatur kann beispielsweise gradweise oder mit Sprüngen von 5 °C erfolgen. Die Wahl der Messwertabstände hängt im Wesentlichen von der gewünschten Genauigkeit und der maximalen Messdauer zur Erfassung der Kennlinie ab.

In einem nächsten Schritt werden die Messergebnisse visualisiert. Zwischen zwei Messwerten liegende Werte können interpoliert werden, beispielsweise durch eine lineare Interpolation. Dieser Schritt ist insbesondere dann erforderlich, wenn die Teilabschnitte und eventuell die Approximation manuell vorgenommen werden soll. Andernfalls kann auf diesen Schritt auch verzichtet werden.

In einem weiteren Schritt wird die Kurve, die aus den erfassten Messwerten gebildet worden ist, in Teilabschnitte unterteilt und eine Approximation der Teilabschnitte mit Hilfe linearer oder polynomialer Funktion bestimmt. Dabei werden vorzugsweise maximal Polynome zweiter Ordnung verwendet. Die Bestimmung der Teilabschnitte und der Approximationen kann manuell erfolgen. Allerdings sind auch automatisierte Verfahren bekannt, die derartige Approximationen bestimmen werden können.

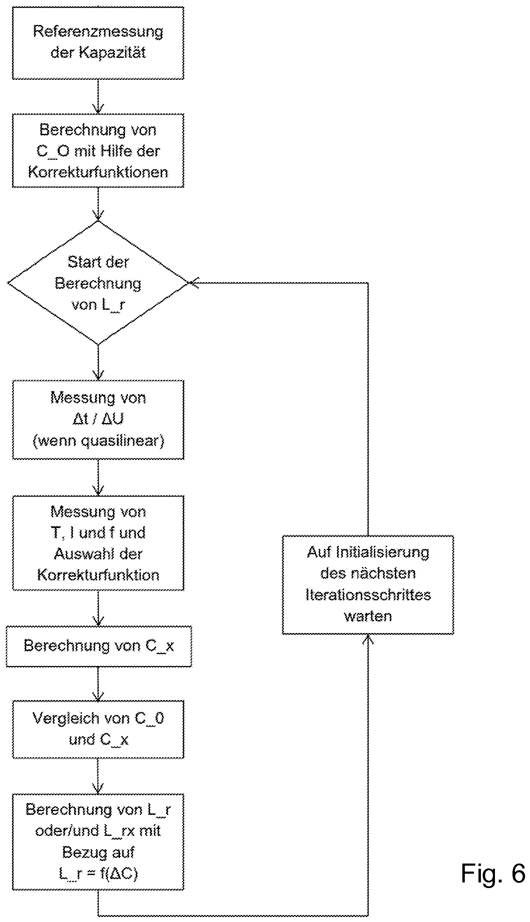

In Fig. 6 ist ein Flussdiagramm dargestellt, das ein Ausführungsbeispiel eines erfindungsgemäßen Verfahrens darstellt. Zu Beginn des Ablaufs werden in einem ersten Schritt Referenzmessungen an der Kapazität durchgeführt. Dabei ist die Kapazität bereits in die Schaltung eingebaut. In einem nächsten Schritt wird dann daraus die Initialkapazität $C_0$ berechnet. Diese Schritte können mehrfach wiederholt werden, wobei dann am Ende der Wiederholungen das Bilden eines Mittelwerts aus allen zuvor bestimmen Initialkapazitätswerten erfolgen würde.

In einem nächsten Schritt folgt die Berechnung der Restlebensdauer $L_r$. Hierzu wird im quasilinearen Bereich der Entladephase des Kondensators über eine Entladezeit $\Delta t$ eine Spannungsänderung $\Delta U$ der Spannung über dem Kondensator gemessen. Hierzu wird am Beginn und am Ende der Entladezeit $\Delta t$ jeweils die Zwischenkreisspannung gemessen und die Spannungsänderung $\Delta U$ als Differenz der beiden Spannungswerte ermittelt. Des Weiteren wird die Temperatur T, der Entladestrom I und die Frequenz des Entladestroms ermittelt bzw. gemessen. In diesem Fall soll nach der Temperaturabhängigkeit, der Frequenzabhängigkeit, der Spannungsabhängigkeit und der Stromabhängigkeit korrigiert werden. Hierzu ist für alle Einflussgrößen jeweils eine Kennlinie vorhanden, die jeweils abschnittsweise approximiert ist. Je nach Messwert für Temperatur, Frequenz, Spannung bzw. Strom muss der entsprechend passende Teilabschnitt der jeweiligen Kennlinie gewählt werden. Wenn beispielsweise eine Temperatur von 43 °C gemessen wurde, so müsste - bei Annahme der Kennlinie entsprechend Fig. 3 - der zweite Teilabschnitt gewählt werden.

In einem nächsten Schritt würde dann die korrigierte Kapazität $C_x$ berechnet. Hierzu werden nacheinander die vier Fehlerkorrekturen durchgeführt, wobei jeweils der korrigierte Kapazitätswert der vorhergehenden Korrektur in die aktuelle Fehlerkorrektur einfließt. Wenn beispielsweise zunächst eine Korrektur des Temperatureinflusses und dann eine Korrektur des Frequenzeinflusses durchgeführt wird, würde der um den Temperatureinfluss korrigierte Kapazitätswert $C_{x,T}$ als zu korrigierender Wert in die Korrektur des Frequenzeinflusses eingehen.

In einem weiteren Schritt wird die korrigierte Kapazität $C_x$ mit der Initialkapazität $C_0$ verglichen und eine Abweichung der beiden Werte voneinander bestimmt. Üblicherweise wird diese Abweichung prozentual angegeben werden. Mit dieser Abweichung wird dann - basierend auf einer Lebensdauerkennlinie - die Restlebensdauer $L_r$ und/oder $L_{rx}$ berechnet. Die Restlebensdauer $L_r$ stellt die zu erwartende Restlebensdauer dar, wenn der Kondensator weiterhin mit den aktuellen Betriebsbedingungen betrieben würde. Die Restlebensdauer $L_{rx}$ ist auf Referenzbetriebsbedingungen umgerechnet. Nach erfolgreicher Berechnung der Restlebensdauer wird auf die Initialisierung der nächsten Iteration gewartet und die Schritte für die Berechnung der Restlebensdauer erneut gestartet. Dabei kann die Iteration beispielsweise durch Ablauf einer bestimmten Zeit neu getriggert werden.

Hinsichtlich weiterer vorteilhafter Ausgestaltungen der erfindungsgemäßen Lehre wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

Bezugszeichenliste

| | |
|---|---|
| T | Temperatur des Kondensators |
| $\Delta t$ | Entladezeit (in der Messung stattfindet) |
| $\Delta U$ | Spannungsänderung über dem Kondensator während einer Entladezeit $\Delta t$ |
| I | Entladestrom während Entladezeit $\Delta t$ |

| | |
|---|---|
| f | Frequenz der Entladestroms I |
| $C_{gemessen}$ | Gemessene Kapazität |
| $C_x$ | Korrigierte Kapazität |
| $C_0$ | Initialkapazität |
| $L_r$ | Restlebensdauer (bezogen auf die aktuellen Betriebsbedingungen) |
| $L_{rx}$ | Restlebensdauer (bezogen auf Referenzrandbedingungen) |
| $L_{rE}$ | Lebensdauerende |
| $U_{in}$ | Eingangsspannung an Schaltung |
| $U_{gl}$ | Gleichgerichtete Eingangsspannung |
| $U_{ZK}$ | Spannung über Kondensator / Zwischenkreisspannung |

**Patentansprüche**

1. Verfahren zum Ermitteln der Restlebensdauer eines Kondensators, wobei der Kondensator zumindest einmalig aufgeladen und entladen wird, umfassend die Schritte:

   Messen einer Spannungsänderung ($\Delta U$) über dem Kondensator während einer Entladezeit ($\Delta t$),
   Bestimmen eines Entladestroms (I) während der Entladezeit ($\Delta t$),
   Ermitteln einer Istkapazität ($C_{gemessen}$) des Kondensators anhand der Spannungsänderung ($\Delta U$), des Entladestroms (I) und der Entladezeit ($\Delta t$),
   Bestimmen einer korrigierten Kapazität ($C_x$) des Kondensators aus der Istkapazität ($C_{gemessen}$) mittels einer Fehlerkorrektur, wobei bei der Fehlerkorrektur Einflüsse der Temperatur (T) auf die Kapazität des Kondensators korrigiert werden, und
   Ermitteln der Restlebensdauer ($L_r$, $L_{rx}$) basierend auf einer Differenz zwischen der korrigierten Kapazität ($C_x$) und einer Initialkapazität ($C_0$) des Kondensators.

2. Verfahren nach Anspruch 1, **dadurch gekennzeichnet, dass** bei dem Schritt des Bestimmens der korrigierten Kapazität ($C_x$) zusätzlich eine Fehlerkorrektur hinsichtlich des Einflusses der Frequenz des Entladestroms (I) während der Entladezeit ($\Delta t$) und/oder der Spannung (U) über dem Kondensator während der Entladezeit ($\Delta t$) und/oder des Entladestroms (I) während der Entladezeit ($\Delta t$) auf die Kapazität durchgeführt wird.

3. Verfahren nach Anspruch 1 oder 2, **dadurch gekennzeichnet, dass** die Fehlerkorrektur/en anhand einer Kennlinie des Kondensators durchgeführt wird, wobei die Kennlinie eine Abhängigkeit der Kapazität des Kondensators von der jeweils korrigierten Einflussgröße beschreibt.
   wobei die Kennlinie durch mehrere Teilabschnitte approximiert werden kann, wobei die Teilabschnitte vorzugsweise stetig ineinander übergehen und vorzugsweise durch Polynome erster oder zweiter Ordnung beschreibbar sind.

4. Verfahren nach einem der Ansprüche 1 bis 3, **dadurch gekennzeichnet, dass** die Temperatur des Kondensators gemessen wird oder dass die Temperatur basierend auf einer Umgebungstemperatur des Kondensators unter Berücksichtigung der Spannung (U) über dem Kondensator, des Entladestroms (I) durch den Kondensator und/oder der Frequenz des Entladestroms abgeschätzt wird.

5. Verfahren nach einem der Ansprüche 1 bis 4, **dadurch gekennzeichnet, dass** für ein Lebensdauerende ($L_{rE}$) entschieden wird, wenn die korrigierte Kapazität ($C_x$) um mehr als einen vorgebbaren Anteil unter die Initialkapazität ($C_0$) abgesunken ist, wobei der vorgebbare Anteil vorzugsweise zwischen 15% und 50%, besonders bevorzugter Weise zwischen 15% und 30%, ganz besonders bevorzugter Weise bei 20% liegt.

6. Verfahren nach einem der Ansprüche 1 bis 5, **dadurch gekennzeichnet, dass** die Entladezeit ($\Delta t$) derart gewählt wird, dass der Kondensator während der Entladezeit ($\Delta t$) quasilinear entladen wird.

7. Verfahren nach einem der Ansprüche 1 bis 6, **dadurch gekennzeichnet, dass** bei der Bestimmung der Spannungsänderung ($\Delta U$) die Spannung über dem Kondensator zu Beginn der Entladezeit ($\Delta t$) und die Spannung über dem Kondensator am Ende der Entladezeit ($\Delta t$) gemessen wird und dass die Spannungsänderung ($\Delta U$) als Differenz dieser beiden Spannungen berechnet wird.

8. Verfahren nach einem der Ansprüche 1 bis 7, **dadurch gekennzeichnet, dass** die Initialkapazität ($C_0$) bei einer ersten Inbetriebnahme des Kondensators ermittelt wird, wobei hierbei wie bei dem Bestimmen der korrigierten

Kapazität ($C_x$) vorgegangen wird, und/oder

dass bei dem Ermitteln der Initialkapazität ($C_0$) mehrere Messungen durchgeführt werden und dass der abgespeicherte Wert der Initialkapazität ($C_0$) als Mittelwert der Messwerte aus den mehreren Messungen ermittelt wird,
wobei vorzugsweise das Ermitteln der Initialkapazität ($C_0$) erst nach Ablauf einer Burn-in-Periode durchgeführt wird.

9. Bewertungseinheit zum Ermitteln der Restlebensdauer eines Kondensators mittels eines Verfahrens nach einem der Ansprüche 1 bis 8, umfassend:

einen Spannungseingang, der zum Eingeben eines Messwerts für eine Spannungsänderung ($\Delta U$) über dem Kondensator während einer Entladezeit ($\Delta t$) ausgebildet ist,
einen Stromeingang, der zum Eingeben eines Messwerts für den Entladestrom (I) ausgebildet ist, wobei der Entladestrom (I) während der Entladezeit ($\Delta t$) ermittelt worden ist,
einer Kapazitätsermittlungseinheit, die zum Ermitteln einer Istkapazität ($C_{gemessen}$) des Kondensators anhand der Spannungsänderung ($\Delta U$), des Entladestroms (I) und der Entladezeit ($\Delta t$) ausgebildet ist,
eine Korrektureinheit, die zum Bestimmen einer korrigierten Kapazität ($C_x$) aus der Istkapazität ($C_{gemessen}$) mittels einer Fehlerkorrektur ausgebildet ist, wobei bei der Fehlerkorrektur Einflüsse der Temperatur (T) auf die Kapazität des Kondensators korrigiert werden, und
einer Auswerteeinheit, die dazu ausgebildet ist, basierend auf einer Differenz zwischen der korrigierten Kapazität ($C_x$) und einer Initialkapazität ($C_0$) des Kondensators die Restlebensdauer ($L_r$, $L_{rx}$) des Kondensators zu ermitteln.

10. System bestehend aus einer Schaltung und einer Bewertungseinheit nach Anspruch 9, wobei die Schaltung mindestens einen Kondensator umfasst, dessen Restlebensdauer ($L_r$, $L_{rx}$) durch die Bewertungseinheit bestimmt werden soll und der im Betrieb der Schaltung zumindest einmalig, vorzugsweise wiederholt, ganz besonders bevorzugter Weise periodisch aufgeladen und entladen wird.

11. System nach Anspruch 10, **dadurch gekennzeichnet, dass** die Schaltung einen Gleichspannungszwischenkreis umfasst, in dem der mindestens eine Kondensator als Pufferkondensator zum Einsatz kommt.

12. System nach Anspruch 10 oder 11, **gekennzeichnet durch** eine Zwischenkreisüberwachung, wobei die Zwischenkreisüberwachung die Spannung über dem Kondensator misst und an den Spannungseingang der Bewertungseinheit eingibt.

13. System nach einem der Ansprüche 10 bis 12, **gekennzeichnet durch** eine Stromermittlungseinheit, wobei die Stromermittlungseinheit einen Stromsensor zum Messen des Entladestroms (I) umfasst oder wobei die Stromermittlungseinheit zum Berechnen des Entladestroms (I) basierend auf weiteren Messwerten anderer physikalischer Größen innerhalb der Schaltung ausgebildet ist, wobei die weiteren Messwerte vorzugsweise eine durch eine Wechselrichterschaltung der Schaltung abgegebene Leistung und eine Spannung an dem Kondensator umfassen.

14. System nach einem der Ansprüche 10 bis 13, **gekennzeichnet durch** eine Frequenzermittlungseinheit zum Ermitteln einer Frequenz des Entladestroms (I), wobei die Frequenzermittlungseinheit die Frequenz des Entladestroms (I) vorzugsweise aus einer Frequenz eines Ansteuersignals für eine Leistungsstufe der Schaltung ableitet.

15. System nach einem der Ansprüche 10 bis 14, **gekennzeichnet durch** eine Ausgabeeinheit, wobei die Ausgabeeinheit zum Ausgeben der ermittelten Restlebensdauer und/oder zum Ausgeben einer Warnung bei Erreichen der Restlebensdauer ausgebildet ist.

**Claims**

1. Method for establishing the remaining service-life of a capacitor, wherein the capacitor is charged and discharged at least once, comprising the steps of:

measuring a voltage change ($\Delta U$) across the capacitor during a discharge time ($\Delta t$),
determining a discharge current (I) during the discharge time ($\Delta t$),

establishing an actual capacitance ($C_{gemesssen}$) of the capacitor with reference to the voltage change ($\Delta U$), the discharge current (I) and the discharge time ($\Delta t$),

determining a corrected capacitance ($C_x$) of the capacitor from the actual capacitance ($C_{gemesssen}$) by means of an error correction, wherein during the error correction influences of the temperature (T) on the capacitance of the capacitor are corrected, and

establishing the remaining service-life ($L_r$, $L_{rx}$) based on a difference between the corrected capacitance ($C_x$) and an initial capacitance ($C_0$) of the capacitor.

2. Method according to claim 1, **characterised in that** in the step of determining the corrected capacitance ($C_x$) an error correction with regard to the influence of the frequency of the discharge current (I) during the discharge time ($\Delta t$) and/or the voltage (U) across the capacitor during the discharge time ($\Delta t$) and/or the discharge current (I) during the discharge time ($\Delta t$) is additionally carried out on the capacitor.

3. Method according to claim 1 or 2, **characterised in that** the error correction(s) is/are carried out with reference to a characteristic line of the capacitor, wherein the characteristic line describes a dependency of the capacitance of the capacitor on the influencing variable which is corrected in each case,

wherein the characteristic line can be approximated by means of a plurality of part-portions, wherein the part-portions preferably merge constantly into each other and can preferably be described by means of polynomials of the first or second order.

4. Method according to any one of claims 1 to 3,

**characterised in that** the temperature of the capacitor is measured or **in that** the temperature is estimated based on an ambient temperature of the capacitor taking into account the voltage (U) across the capacitor, the discharge current (I) through the capacitor and/or the frequency of the discharge current.

5. Method according to any one of claims 1 to 4,

**characterised in that** a service-life end ($L_{rE}$) is decided upon when the corrected capacitance ($C_x$) has fallen by more than a predeterminable proportion below the initial capacitance ($C_0$), wherein the predeterminable proportion is preferably between 15% and 50%, in a particularly preferred manner between 15% and 30%, in a quite particularly preferred manner 20%.

6. Method according to any one of claims 1 to 5,

**characterised in that** the discharge time ($\Delta t$) is selected in such a manner that the capacitor is discharged in a quasi linear manner during the discharge time ($\Delta t$).

7. Method according to any one of claims 1 to 6,

**characterised in that** during the determination of the voltage change ($\Delta U$) the voltage across the capacitor at the beginning of the discharge time ($\Delta t$) and the voltage across the capacitor at the end of the discharge time ($\Delta t$) is measured and **in that** the voltage change ($\Delta U$) is calculated as the difference of these two voltages.

8. Method according to any one of claims 1 to 7,

**characterised in that** the initial capacitance ($C_0$) when the capacitor is first activated is established, wherein in this instance the same procedure is carried out as for the determination of the corrected capacitance ($C_x$), and/or

**in that**, when the initial capacitance ($C_0$) is established, a plurality of measurements are carried out and **in that** the stored value of the initial capacitance ($C_0$) is established as the mean value of the measurement values from the plurality of measurements,

wherein the establishment of the initial capacitance ($C_0$) is preferably carried out only after completion of a burn-in period.

9. Evaluation unit for establishing the remaining service-life of a capacitor by means of a method according to any one of claims 1 to 8, comprising:

a voltage input which is constructed to input a measurement value for a voltage change ($\Delta U$) across the capacitor during a discharge time ($\Delta t$),

a power input which is constructed to input a measurement value for the discharge current (I), wherein the discharge current (I) has been established during the discharge time ($\Delta t$),

a capacitance establishment unit which is constructed to establish an actual capacitance ($C_{gemessen}$) of the capacitor with reference to the voltage change ($\Delta U$), the discharge current (I) and the discharge time ($\Delta t$),

a correction unit which is constructed to determine a corrected capacitance ($C_x$) from the actual capacitance ($C_{gemessen}$) by means of an error correction, wherein during the error correction influences of the temperature (T) on the capacitance of the capacitor are corrected, and

an evaluation unit which is constructed based on a difference between the corrected capacitance ($C_x$) and an initial capacitance ($C_0$) of the capacitor to establish the remaining service-life ($L_r$, $L_{rx}$) of the capacitor.

10. System comprising a circuit and an evaluation unit according to claim 9, wherein the circuit comprises at least one capacitor whose remaining service-life ($L_r$, $L_{rx}$) is intended to be determined by the evaluation unit and which during operation of the circuit is charged and discharged at least once, preferably repeatedly, and in a quite particularly preferred manner periodically.

11. System according to claim 10, **characterised in that** the circuit comprises a direct-current voltage intermediate circuit, in which at least one capacitor is used as a buffer capacitor.

12. System according to claim 10 or 11, **characterised by** an intermediate circuit monitoring, wherein the intermediate circuit monitoring measures the voltage across the capacitor and inputs it at the voltage input of the evaluation unit.

13. System according to any one of claims 10 to 12,
**characterised by** a current establishment unit, wherein the current establishment unit comprises a current sensor for measuring the discharge current (I) or wherein the current establishment unit is constructed to calculate the discharge current (I) based on additional measurement values of other physical variables within the circuit, wherein the additional measurement values preferably comprise a power which is discharged by means of an inverter circuit of the circuit and a voltage at the capacitor.

14. System according to any one of claims 10 to 13,
**characterised by** a frequency establishment unit for establishing a frequency of the discharge current (I), wherein the frequency establishment unit derives the frequency of the discharge current (I) preferably from a frequency of a control signal for a power stage of the circuit.

15. System according to any one of claims 10 to 14,
**characterised by** an output unit, wherein the output unit is constructed to output the established remaining service-life and/or to output a warning when the remaining service-life is reached.

**Revendications**

1. Procédé pour la détermination de la durée de vie restante d'un condensateur, dans lequel le condensateur est chargé et déchargé au moins une fois, comprenant les étapes suivantes :

mesure d'une variation de tension ($\Delta U$) aux bornes du condensateur pendant un temps de décharge ($\Delta t$),
détermination d'un courant de décharge (I) pendant le temps de décharge ($\Delta t$),
détermination d'une capacité réelle ($C_{gemessen}$) du condensateur à l'aide de la variation de tension ($\Delta U$), du courant de décharge (I) et du temps de décharge ($\Delta t$),
détermination d'une capacité corrigée ($C_x$) du condensateur à partir de la capacité réelle ($C_{gemessen}$) au moyen d'une correction d'erreur, dans lequel, lors de la correction d'erreur, les influences de la température (T) sur la capacité du condensateur sont corrigées et
détermination de la durée de vie restante ($L_r$, $L_{rx}$) sur la base d'une différence entre la capacité corrigée ($C_x$) et une capacité initiale ($C_0$) du condensateur.

2. Procédé selon la revendication 1, **caractérisé en ce que**, à l'étape de détermination de la capacité corrigée ($C_x$), est effectuée en outre une correction d'erreur concernant l'influence de la fréquence du courant de décharge (I) pendant le temps de décharge ($\Delta t$) et/ou la tension (U) aux bornes du condensateur pendant le temps de décharge ($\Delta t$) et/ou le courant de décharge (I) pendant le temps de décharge ($\Delta t$) sur la capacité.

3. Procédé selon la revendication 1 ou 2, **caractérisé en ce que** la ou les corrections d'erreur sont effectuées à l'aide d'une courbe caractéristique du condensateur, dans lequel la courbe caractéristique décrit une dépendance de la capacité du condensateur de la grandeur d'influence corrigée,
dans lequel la courbe caractéristique peut être approximée par plusieurs parties, dans lequel les parties s'enchaînent de manière continue les unes aux autres et peuvent être décrites de préférence par des polynômes de premier ou de deuxième ordre.

4. Procédé selon l'une des revendications 1 à 3, **caractérisé en ce que** la température du condensateur est mesurée ou **en ce que** la température est évaluée sur la base d'une température ambiante du condensateur en tenant compte de la tension (U) aux bornes du condensateur, du courant de décharge (I) à travers le condensateur et/ou de la fréquence du courant de décharge.

5. Procédé selon l'une des revendications 1 à 4, **caractérisé en ce que**, pour une fin de durée de vie ($L_{rE}$), il est décidé, lorsque la capacité corrigée ($C_x$) a diminué de plus d'une part prédéterminée sous la capacité initiale ($C_0$), dans lequel la part prédéterminée se trouve de préférence entre 15 % et 50 %, plus particulièrement de préférence entre 15 % et 30 %, de préférence de 20 %.

6. Procédé selon l'une des revendications 1 à 5, **caractérisé en ce que** le temps de décharge ($\Delta t$) est choisi de façon à ce que le condensateur est décharge de manière quasilinéaire pendant le temps de décharge ($\Delta t$).

7. Procédé selon l'une des revendications 1 à 6, **caractérisé en ce que**, lors de la détermination de la variation de tension ($\Delta U$), la tension aux bornes du condensateur est mesurée au début du temps de décharge ($\Delta t$) et la tension aux bornes du condensateur est mesurée à la fin du temps de décharge ($\Delta t$) et **en ce que** la variation de tension ($\Delta U$) est calculée comme une différence entre ces deux tensions.

8. Procédé selon l'une des revendications 1 à 7, **caractérisé en ce que** la capacité initiale ($C_0$) est déterminée lors d'une première mise en service du condensateur, dans lequel il est procédé comme lors de la détermination de la capacité corrigée ($C_x$) et/ou

   **en ce que**, lors de la détermination de la capacité initiale (Co), plusieurs mesures sont effectuées et **en ce que** la valeur enregistrée de la capacité initiale ($C_0$) est déterminée comme la moyenne des valeurs de mesure des plusieurs mesures,
   dans lequel, de préférence, la détermination de la capacité initiale ($C_0$) n'est effectuée que lors de l'écoulement d'une période de burn-in.

9. Unité d'évaluation pour la détermination de la durée de vie restante d'un condensateur au moyen d'un procédé selon l'une des revendications 1 à 8, comprenant :

   une entrée de tension, qui est conçue pour l'entrée d'une valeur de mesure pour une variation de tension ($\Delta U$) aux bornes du condensateur pendant un temps de décharge ($\Delta t$),
   une entrée de courant, qui est conçue pour l'entrée d'une valeur de mesure pour le courant de décharge (I), dans lequel le courant de décharge (I) a été déterminé pendant le temps de décharge ($\Delta t$),
   une unité de détermination de capacité qui est conçue pour la détermination d'une capacité réelle ($C_{gemessen}$) du condensateur à l'aide de la variation de tension ($\Delta U$), du courant de décharge (I) et du temps de décharge ($\Delta t$),
   une unité de correction qui est conçue pour la détermination d'une capacité corrigée ($C_x$) à partir de la capacité réelle ($C_{gemessen}$) au moyen d'une correction d'erreur, dans lequel, lors de la correction d'erreur, l'influence de la température (T) sur la capacité du condensateur est corrigée et
   une unité d'analyse qui est conçue pour déterminer la durée de vie restante ($L_r$, $L_{rx}$) du condensateur sur la base d'une différence entre la capacité corrigée ($C_x$) et une capacité initiale ($C_0$) du condensateur.

10. Système constitué d'un circuit et d'une unité d'évaluation selon la revendication 9, dans lequel le circuit comprend au moins un condensateur dont la durée de vie restante ($L_r$, $L_{rx}$) doit être déterminée par l'unité d'évaluation, et qui est chargé et déchargé au moins une fois, de préférence de manière répétée, de préférence de manière périodique, lors du fonctionnement du circuit.

11. Système selon la revendication 10, **caractérisé en ce que** le circuit comprend un circuit intermédiaire à courant continu dans lequel au moins un condensateur est utilisé comme condensateur tampon.

12. Système selon la revendication 10 ou 11, **caractérisé par** une surveillance du circuit intermédiaire, dans lequel la surveillance du circuit intermédiaire mesure la tension aux bornes du condensateur et l'entre au niveau de l'entrée de tension de l'unité d'évaluation.

13. Système selon l'une des revendications 10 à 12, **caractérisé par** une unité de détermination de courant, dans lequel l'unité de détermination de courant comprend un capteur de courant pour la mesure du courant de décharge (I) ou dans lequel l'unité de détermination de courant est conçue pour le calcul du courant de décharge (I) sur la base d'autres valeurs de mesure d'autres grandeurs physiques à l'intérieur du circuit, dans lequel les autres valeurs de mesure comprennent de préférence une puissance générée par un branchement de convertisseur du circuit et une tension au niveau du condensateur.

14. Système selon l'une des revendications 10 à 13, **caractérisé par** une unité de détermination de fréquence pour la détermination d'une fréquence du courant de décharge (I), dans lequel l'unité de détermination de fréquence déduit la fréquence du courant de décharge (I) de préférence à partir d'une fréquence d'un signal de commande pour un étage de puissance du circuit.

15. Système selon l'une des revendications 10 à 14, **caractérisé par** une unité de sortie, dans lequel l'unité de sortie est conçue pour la sortie de la durée de vie restante déterminée et/ou pour la sortie d'un avertissement lorsque la durée de vie restante est atteinte.

Fig. 1

$$C \sim \frac{\Delta t}{\Delta U} \approx const.$$

$U_{ZK}$

$U_{gl}$

$U_{gl}$

$U_{in}$

$\Delta t$

U

t

Fig. 2

Auswertung ΔC=f(T)

Fig. 3

Fig. 4

Messung C = f(x)
(mit x = T, U, I oder f)

Visualisierung der
Ergebnisse in einer
Kurve

Aufteilung der Kurve
in Teilabschnitte zur
approximierten
Beschreibung der
Teilabschnitte mit
Hilfe einfacher
linearer oder
polynominal
Funktionen

Fig. 5

```
┌─────────────────────┐
│   Referenzmessung    │
│   der Kapazität      │
└─────────────────────┘
          │
          ▼
┌─────────────────────┐
│   Berechnung von     │
│   C_O mit Hilfe der  │
│   Korrekturfunktionen│
└─────────────────────┘
          │
          ▼
      ╱╲
    ╱    ╲
  ╱  Start der ╲
 ◄  Berechnung  ◄────────────────────┐
  ╲  von L_r   ╱                      │
    ╲        ╱                        │
      ╲    ╱                          │
        ╲╱                            │
          │                           │
          ▼                           │
┌─────────────────────┐               │
│   Messung von        │    ┌──────────────────────┐
│   Δt / ΔU            │    │  Auf Initialisierung  │
│   (wenn quasilinear) │    │  des nächsten         │
└─────────────────────┘    │  Iterationsschrittes  │
          │                │  warten               │
          ▼                └──────────────────────┘
┌─────────────────────┐               ▲
│   Messung von        │               │
│   T, I und f und     │               │
│   Auswahl der        │               │
│   Korrekturfunktion  │               │
└─────────────────────┘               │
          │                           │
          ▼                           │
┌─────────────────────┐               │
│  Berechnung von C_x  │               │
└─────────────────────┘               │
          │                           │
          ▼                           │
┌─────────────────────┐               │
│   Vergleich von C_0  │               │
│   und C_x            │               │
└─────────────────────┘               │
          │                           │
          ▼                           │
┌─────────────────────┐               │
│  Berechnung von L_r  │               │
│  oder/und L_rx mit   │               │
│  Bezug auf           │               │
│  L_r = f(ΔC)         │               │
└─────────────────────┘               │
          │                           │
          └───────────────────────────┘
```

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP H792213 A
- DE 102012105198 A1
- EP 1338874 A1
- DE 102004035723 A1
- US 2009072982 A
- US 20090088993 A1
- DE 102012215963 A1
- DE 112009000643 T5